(19) Europäisches Patentamt
European Patent Office
Office européen des brevets

(11) Numéro de publication: 0 043 776
B1

# (12) FASCICULE DE BREVET EUROPEEN

(45) Date de publication du fascicule du brevet: **31.10.84**

(51) Int. Cl.³: **C 04 B 35/50,** C 30 B 11/04, C 30 B 29/22, C 01 F 17/00, H 01 S 3/16

(21) Numéro de dépôt: **81401087.2**

(22) Date de dépôt: **07.07.81**

(54) **Oxydes mixtes d'aluminium, leur procédé de fabrication et leur application.**

(30) Priorité: **08.07.80 FR 8015171**

(43) Date de publication de la demande: **13.01.82 Bulletin 82/2**

(45) Mention de la délivrance du brevet: **31.10.84 Bulletin 84/44**

(84) Etats contractants désignés: **AT BE CH DE FR GB IT LI LU NL SE**

(56) Documents cités:
**FR - A - 997 615**
**FR - A - 1 347 015**
**FR - A - 2 205 737**
**FR - A - 2 436 753**
**FR - A - 2 442 264**
**US - A - 3 252 103**
**US - A - 3 725 811**

**JOURNAL OF LUMINESCENCE, vol. 2, 3 avril 1979 North-Holland Publishing Co. NL STEVELS: "Red Mn2+luminescence in hexagonal aluminates" pages 99-109**
**CHEMICAL ABSTRACTS, vol. 85, no. 22, 29 novembre 1976, réf. 169268j Columbus, Ohio, USA J.L. SOMMERDIGK et al. "Decay of the C1 ion luminescence of Ce activated LaMgA111019 and of CeMgA111019**

(73) Titulaire: **CENTRE NATIONAL DE LA RECHERCHE SCIENTIFIQUE, 26, rue Boyer, F-75020 Paris (FR)**

(72) Inventeur: **Kahn, Andrée, c/o ENSCP 11 rue Pierre et Marie Curie, F-75231 Paris Cedex 05 (FR)**
Inventeur: **Lejus, Anne-Marie, 10, rue Louis Lejeune, F-92120 Montrouge (FR)**
Inventeur: **Thery, Jeanine, 15, rue Poliveau, F-75005 Paris (FR)**
Inventeur: **Vivien, Daniel, 6, Clos de la Source, F-92380 Garches (FR)**

(74) Mandataire: **Mongrédien, André et al, c/o BREVATOME 25, rue de Ponthieu, F-75008 Paris (FR)**

(56) Documents cités: (suite)
**activated with Tb3 + or Eu 3 + ions"**

EP 0 043 776 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**Description**

La présente invention concerne des oxydes mixtes d'aluminium, leur procédé de fabrication et leur application.

De façon plus précise, l'invention concerne des oxydes mixtes d'aluminium obtenus sous forme de monocristaux et trouvant une application particulière dans le domaine des microlasers pour l'optique intégrée ou les télécommunications par fibres optiques et dans le domaine des lasers de puissance émettant dans l'infrarouge permettant par exemple d'effectuer des traitements de matériaux, des réactions photochimiques et la fusion thermonucléaire contrôlée.

On connaît actuellement des oxydes mixtes d'aluminium et en particulier des aluminates mixtes de lanthane-magnésium, de cérium-magnésium, de lanthane-manganèse et de cérium-manganèse, de formule chimique $LnMAl_{11}O_{19}$ où Ln représente le lanthane ou le cérium et M le magnésium ou le manganèse. Ces oxydes mixtes d'aluminium fabriqués par la société Philips peuvent être dopés par des ions luminophores tels que les ions $Ce^{3+}$, $Tb^{3+}$, $Eu^{2+}$, $Mn^{2+}$.

Ces oxydes mixtes dopés ou non et obtenus uniquement sous forme de poudres, possèdent des propriétés luminescentes importantes (dispositif d'affichage, . . .) mais ne présentent pas l'effet laser. Leurs procédés de fabrikation et leurs propriétés optiques (luminescence) sont décrits dans plusieurs articles tels que par exemple un article intitulé »Cerium and Terbium luminescence in $LaMgAl_{11}O_{19}$« paru dans le Journal of Luminescence 6 (1973), pages 425 à 431 et dans un autre article intitulé »Red $Mn^{2+}$ luminescence in hexagonal aluminates« paru dans le Journal of Luminescence 20 (1979), pages 99 à 109.

L'invention a pour objet des oxydes mixtes d'aluminium obtenus sous forme de monocristaux et qui présentent notamment des propriétés optiques permetant de les utiliser comme émetteur pur laser.

Ces oxydes mixtes d'aluminium se caractérisent en ce qu'ils présentent la formule suivante:

$$X^1{}_{(x_1-x_2)}X^2{}_{(x_2)}M^1{}_{(y_1-y_2)}M^2{}_{(y_2)}Al_{(z_1-z_2)}M^3{}_{(z_2)}O_{19}$$

dans laquelle, $X^1$ représente le lanthane ou le gadolinium; $X^2$ représente le néodyme; $M^1$ et $M^2$ qui peuvent être identiques ou différentes représentent un métal choisi pazmi le magnésium et les métaux de transition bivalents; $M^3$ représente un métal de transition trivalent; $x_1$ représente un nombre allant de 0,8 à 1; $y_1$ représente un nombre allant de 0,7 à 1; $z_1$ représente un nombre allant de 10 à 12; $x_2$ représente un nombre tel que $0 < x_2 \leq x_1$; $y_2$ représente un nombre allant de 0 à $y_1$; et $z_2$ représente un nombre allant de 0 à 1, et en ce qu'il présente une structure cristalline du type magnétoplombite.

Il est à noter que ces oxydes mixtes d'aluminium sont, bien entendu, des composés monophasés.

Ces oxydes mixtes d'aluminium peuvent présenter une composition stoechiométrique telle que $x_1$ soit égal à 1, $y_1$ à 1 et $z_1$ à 11, mais peuvent aussi présenter une composition légèrement différente quant à la proportion relative des ions lanthanides, c'est-à-dire des ions de $X^1$ et $X^2$, des ions bivalents, c'est-à-dire des ions de $M^1$ et $M^2$, et des ions trivalents, c'est-à-dire des ions de $M^3$ et d'aluminium, à condition que la structure cristalline de ces oxydes soit du type magnétoplombite.

De façon avantageuse, ces oxydes mixtes d'aluminium présentent une composition, outre une composition stoechiométrique, telle que $x_1$ soit égal à 0,95, $y_1$ à 1, $z_1$ à 11 ou bien telle que $x_1$ soit égal à 1, $y_1$ à 0,9 et $z_1$ à 11.

De façon avantageuse, les métaux de transition bivalents sont choisis pazmi le manganèse, le fer, le nickel et le cobalt et le métal de transition trivalent est le chrome.

De préférence, selon l'invention, l'oxyde mixte d'aluminium présente la formule:

$$La_{0,9}Nd_{0,1}MgAl_{11}O_{19}$$

Cet oxyde mixte est particulièrement bien adapté comme émetteur pour laser car il présente des propriétés optiques comparables à celles que possèdent le grenat d'yttrium et d'aluminium de formule $Y_3Al_5O_{12}$ dans lequel 1% des ions yttrium ont été substitués par des ions néodyme et connu sous le nom anglosaxon de YAG et l'ultraphosphate de néodyme ($NdP_5O_{14}$) utilisés couramment comme émetteur pour laser travaillant dans l'infrarouge.

Ces oxydes mixtes sont obtenus à partir d'un premier procédé se caractérisant en ce que l'on mélange intimement dans des proportions convenables les poudres des oxydes de $X^1$, $X^2$, $M^1$, $M^2$, $M^3$ et d'aluminium et en ce que l'on fond le mélange obtenu.

Selon une autre caractéristique de ce premier procédé, on traite le mélange fondu de façon à obtenir par solidifaction dudit mélange un monocristal.

Ces oxydes mixtes peuvent aussi être obtenus à partir d'un second procédé se caractérisant en ce que l'on coprécipite les hydroxydes de sels de $X^1$, $X^2$, $M^1$, $M^2$, $M^3$ et d'aluminium, dissous dans un solvant non aqueux dans des proportions convenables et en ce que l'on calcine le coprécipité optenu.

Selon une autre caractéristique de ce second procédé, on fond le coprécipité après broyage de celui-ci et on traite le coprécipité fondu de façon à obtenir par solidification dudit coprécipité un monocristal.

D'autres caractéristiques et avantages de l'invention ressortiront mieux à l'aide de la description qui

va suivre, donnée à titre purement illustratif et non limitatif, en référence aux figures annexées, dans lesquelles:

la figure 1 représente schématiquement un dispositif d'obtention d'un monocristal d'oxydes mixtes d'aluminium selon l'invention;

la figure 2 représente schématiquement le diagramme d'émissions de fluorescence de l'oxyde mixte $Nd_{0,1}La_{0,9}MgAl_{11}O_{19}$.

A titre d'exemple, on décrit ci-après la fabrication de l'aluminate mixte de néodyme-magnésium de formule $NdMgAl_{11}O_{19}$.

Pour cela on mélange de façon intime de l'oxyde d'aluminium sous forme de poudre, fourni par l'industrie des Pierres Scientifiques H. Djevahirdjian, 1870 Monthey, Suisse, de l'oxyde de néodyme ($Nd_2O_3$) fourni par la société Rhône-Progil, et de l'oxyde de magnésium ($MgO$) de qualité R. P (oxyde pour analyse) fourni par la société Prolabo, également sous forme de poudre, par exemple, dans les proportions stoechiométriques, c'est-à-dire suivant la réaction chimique:

$$11\ Al_2O_3 + Nd_2O_3 + 2\ MgO \rightarrow 2\ NdMgAl_{11}O_{19}$$

Ces oxydes se présentent sous la forme d'une poudre possédant une granulométrie comprise entre 1 et 10 μ et une pureté supérieure à 99,9%.

Le mélange intime de ces différentes poudres peut se faire soit à l'état solide dans un mortier par broyage, durant environ une demi-heure, soit en dispersant lesdites poudres dans un solvant organique, de préférence l'éther ou l'acétone, de façon à améliorer l'homogénéité du mélange. La suspension est alors agitée vivement pendant une demi-heure environ. Le solvant organique n'ayant aucun rôle chimique est ensuite éliminé par évaporation.

Pour obtenir par exemple 30,7 grammes (g) de mélange on ajoute à 22,400 g d'alumine, 6,730 g d'oxyde de néodyme et 1,600 g d'oxyde de magnésium, constituants possédant les caractéristiques données précédemment.

C'est après fusion de ce mélange intime que peut être obtenu le monocristal de $NdMgAl_{11}O_{19}$.

Pour un oxyde mixte d'aluminium plus complexe contenant par exemple en plus des constituants cités ci-dessus, du lanthane et du chrome, le mélange se fait de la même façon en ajoutant dans les proportions adéquatres de l'oxyde de lanthane ($La_2O_3$) et de l'oxyde de chrome ($Cr_2O_3$) sous forme de poudre.

Les oxydes des lanthanides ($La_2O_3$, $Nd_2O_3$, ...) étant très hydroscopiques, il est nécessaire de les calciner avant de les mélanger aux autres constituants par exemple à une température voisine de 1000° C.

L'obtention de ce monocristal peut avoir lieu soit par la méthode de fusion de zone ou méthode de la zone flottante, soir par induction directe de la haute fréquence en auto-creuset puis refroidissement lent à partir des parois de l'auto-creuset, (méthode connue sous le nom de méthode de Kyropoulos), soit par tirage à partir d'un bain en fusion (méthode connue sous le nom de méthode de Czochralski) soit à partir de la méthode dite de Verneuil. Cette dernière méthode de mise en oeuvre facile permet d'obtenir des monocristaux de grandes dimensions. Cette méthode va maintenant être décrite en se référant au dispositif de mise en oeuvre schématisé sur la figure 1.

Ce dispositif comprend un distributeur de poudre 2 comportant à sa partie inférieure un tamis 4 sur lequel est placé le mélange de poudre 6 obtenu précédemment. Ce tamis 4 présente une ouverture de maille pouvant varier de 125 à 210 μm de façon à permettre le passage des poudres. Ce distributeur de poudre 2 comporte de plus un dispositif à percussion constitué d'un marteau 8 et d'une tige 10 en contact avec le fond du tamis 4.

Lorsque le marteau 8 vient frapper la tige 10, celle-ci se met à vibrer provoquant ainsi la chute d'une certaine quantité de poudre en direction d'une buse 12 d'un chalumeau oxyhydrique. La cadence des coups de marteau peut varier de 10 à 40 coups par minute, ce qui provoque la chute de 1 à 6 milligrammes de poudre à chaque percussion.

Le chalumeau oxhydrique permet de fondre le mélange de poudres 6. L'alimentation du chalumeau en oxygène se fait à l'aide d'un conduit d'amenée 14 situé en haut du distributeur de façon à entraîner la poudre 6 vers la buse 12 du chalumeau; l'alimentation en hydrogène se fait à l'aide d'un conduit d'amenée 16. Le débit d'oxygène variant de 4 à 7 litres par minute (1/mn) sous une pression de l'ordre de 10 millibars (mb) est contrôlé au moyen d'un système de manomètres et de débitmètres schématisés en 18, le débit d'hydrogène variant de 12 à 21 l/mn sous une pression de l'ordre de 2 mb est contrôlé de la même façon au moyen d'un système schématisé en 20.

Le mélange de poudres 6 fondu par l'intermédiaire du chalumeau se dépose alors sur un support 22 en alumine placé à l'intérieur d'un moufle en argile 24 recouvert sur ses faces internes par de l'alumine.

Ce moufle 24 est percé d'une femêtre 26 pouvant être associée à un dispositif optique 28 permettant le contrôle de la formation du monocristal 30 et du maintien du front de cristallisation à un niveau constant. Ce maintien du front de cristallisation dans la flamme 32 du chalumeau est obtenu au moyen d'un dispositif automatique 34 permettant de faire descendre le support 22. Ce support 22 peut aussi être mis en rotation au moyen d'un dispositif automatique 36.

Pour fabriquer le monocristal de l'oxyde mixte d'aluminium, on fixe après mise en route du chalumeau un débit de poudre élevé afin d'obtenir sur le support 22 un cône fritté 38 d'oxyde mixte mesurant environ 10 mm de haut. La chute du mélange de poudres 6 est ensuite arrêtée et la flamme 32 du chalumeau réglée de façon à réaliser la fusion de l'oxyde mixte. Une goutte en fusion qui donnera le germe de cristallisation se forme alors au sommet du cône 38. Cette goutte peut s'étaler sur un diamètre variant de 3 à 10 mm. La croissance du monocristal s'amorce. L'alimentation en poudre 6 est ensuite réglée (nombre de coups de marteau par minute) de façon à maintenir à un niveau constant, c'est-à-dire dans la flamme 32 du chalumeau, le front de cristallisation et une vitesse d'élaboration du monocristal 30 de l'ordre de 10 à 20 mm/heure.

En fin d'opération, l'alimentation en poudre 6 est arrêtée et le monocristal 30 est éloigné progressivement de la flamme 32 du chalumeau. Le refroidissement du monocristal 30, après arrêt du chalumeau, se fait dans le moufle 24, ce qui permet d'éviter toute variation brusque de température; une variation brusque de température risquant de provoquer des craquelures dans le monocristal.

De plus, pour éviter un refroidissement trop rapide du monocristal 30, on ferme la partie inférieure 40 du moufle. Lorsque le monocristal est totalement refroidi, il suffit de le séparer du cône 38 par un simple coup de scie.

De cette façon, on peut obtenir un échantillon par exemple de $NdMgAl_{11}O_{19}$ présentant un diamètre d'environ 15 mm et une longueur de 50 mm. L'élaboration d'un tel échantillon peut durer de 5 à 8 heures et le refroidissement est contrôlé par l'inertie thermique du moufle 40.

Il est à noter que tous les oxydes mixtes selon l'invention présentant une croissance cristalline voisine de celle de l'alumine, leur fabrication sous forme de monocristaux ne semble pas plus difficile que la fabrication de monocristaux d'alumine.

Le monocristal de $NdMgAl_{11}O_{19}$ ainsi que les autres oxydes mixtes d'aluminium selon l'invention peuvent être obtenus au moyen d'un autre procédé de fabrication.

Cet autre procédé de fabrication pour l'oxyde $NdMgAl_{11}O_{19}$ consiste à coprécipiter sous forme amorphe (donc très réactive) les hydroxydes des différent éléments Nd, Mg et Al.

On réalise tout d'abord trois solutions que l'on mélange ensuite dans des proportions convenables, par exemple dans les proportions stoechiométriques, pour conduire à l'oxyde mixte de formule $NdMgAl_{11}O_{19}$.

La première solution est constituée par de l'oxyde de néodyme ($Nd_2O_3$) que l'on dissout dans de l'acide chlorhydrique très concentré, ce qui permet d'obtenir le chlorure correspondant. La seconde solution est constituée par du chlorure de magnésium ($MgCl_2$) que l'on dissout dans de l'alcool absolu, et la troisième par du chlorure d'aluminium ($AlCl_3$) dissout aussi dans de l'alcool absolu.

Le mélange des trois solutions étant réalisé, on coprécipite les hydroxydes correspondants de préférence par de l'ammoniaque. Certains hydroxydes tels que l'hydroxyde de magnésium étant soluble dans l'ammoniaque en solution aqueuse, on réalise la coprécipitation dans un solvant non aqueux comme l'alcool absolu.

Le coprécipité ainsi obtenu est ensuite calciné à une température d'environ 500°C de façon à éliminer le chlorure d'ammonium ($NH_4Cl$) formé lors de l'addition de l'ammoniaque. Le coprécipité ainsi calciné est ensuite broyé.

Comme précédemment, on peut obtenir le monocristal de $NdMgAl_{11}O_{19}$ à partir de ce coprécipité par la méthode dite de Verneuil ou toutes autres méthodes citées plus haut.

Le deuxième procédé selon l'invention présente l'intérêt de donner un mélange très homogène mais il ne peut être généralisé à tous les oxydes mixtes selon l'invention pour diverses considérations chimiques. Au contraire, le premier procédé est applicable à tous les oxydes mixtes d'aluminium selon l'invention, moyennant quelques modifications opératoires au niveau de la fabrication du monocristal suivant que les constituants de base pour la fabrication dudit monocristal sont plus ou moins réducteurs ou oxydants.

Ces oxydes mixtes obtenus comme précédemment présentent une strukture hexagonale intermédiaire entre la structure de la magnétoplombite de formule $BaAl_{12}O_{19}$, la structure de l'alumine $\beta$ au sodium et de l'alumine $\beta$ à l'argent, bien connues de l'homme de l'art.

Les différents oxydes mixtes obtenus sous forme de monocristaux selon les procédés précédemment décrits et en particulier ceux contenant du néodyme présentent des propriétés optiques permettant leur utilisation comme émetteur pour laser.

On sait que l'effet laser dépend de certains paramètres et en particulier de la durée de vie de l'état excité des ions (niveau d'énergie supérieur au niveau fondamental). Si la durée de vie de l'état excité est suffisamment importante (plusieurs dizaines de microsecondes), l'inversion de populatin (le nombre d'ions dans l'état excité est supérieur au nombre d'ions dans l'état fondamental) peut avoir lieu.

Des études ont montré que la présence de néodyme, associé au lanthane ou au gadolinium dans les oxydes mixtes selon l'invention, permet d'obtenir des durées de vie suffisamment importantes pour réaliser cette inversin de population, le gadolinium et le lanthane jouant le même rôle. Dans ces oxydes mixtes, l'état excité correspond au niveau d'énergie $^4F_{3/2}$ de l'ion $Nd^{3+}$.

On va maintenant indiquer dans un tableau la durée de vie de l'état excité $^4F_{3/2}$ en fonction de la quantité d'ions $Nd^{3+}$ par centimètre cube de monocristal pour des oxydes mixtes de formule $Nd_{(1-x}La_{(x)}MgAl_{11}O_{19}$ avec x compris entre 0 et 1.

Le dernier composé de formule $Y_3Al_5O_{12}$ avec 1% de néodyme appelé YAG est donné à titre

comparatif, (voir tableau ci-joint).

D'après ce tableau, on constate que plus le composé mixte contient de lanthane, plus la durée de vie de l'état excité augmente. De plus, pour une concentration d'ions $Nd^{3+}$ comprise entre 0,03 et $0,34 \times 10^{21}/cm^3$, la durée de vie de l'état excité d'un oxyde mixte selon l'invention est supérieure à la durée de vie de l'état excité pour le composé de référence utilisé couramment comme émetteur pour laser.

Il est à noter qu'un oxyde mixte ne contenant que du lanthane, c'est-à-dire de formule $LaMgAl_{11}O_{19}$ ne présente pas d'effet laser. Celui-ci est bien dû à la présence de néodyme dans les oxydes mixtes selon l'invention.

Les propriétés optiques (luminescence ou effet laser) étant caractéristiques des lanthanides cités ci-dessus, le magnésium présent dans l'oxyde mixte considéré peut être remplacé en tout ou partie par le manganèse, le fer, le nickel, le cobalt sous forme bivalent, ces différents éléments jouant le même rôle.

On sait de plus que l'effet laser dépend de la force d'oscillateur des transitions dans les ions luminophores. Cette force d'oscillateur doit être aussi élevée que possible. Les oxydes mixtes selon l'invention possèdent des forces d'oscillateur, lorsque la lumière se propage suivant l'axe C du cristal, voisines de celles par exemple de l'ultraphosphate de néodyme.

L'intensité de la fluorescence augmente avec la concentration en ions néodyme mais une trop grande quantité d'ions $Nd^{3+}$ favorise des interactions entre ions luminophores nuisibles à la fluorescence. La présence de lanthane permettant d'augmenter le rendement de fluorescence, par effet de dilution, l'oxyde mixte de formule $Nd_{0,1}La_{0,9}MgAl_{11}O_{19}$ semble un bon compromis en ce qui concerne la quantité d'ions $Nd^{3+}$.

Le fait d'utiliser pour la fabrication des oxydes mixtes selon l'invention, présentant l'effet laser, des constituants de base possédant une grande pureté (supérieure à 99,9%) permet d'obtenir un bon rendement de fluorescence. En effet, l'existence d'impuretés dans le monocristal conduirait à des pertes de fluorescennce, car les ions néodyme dans l'état excité pourraient se désactiver vers l'état fondamental selon un processus non radiatif.

Des études ont montré que les oxydes mixtes contenant du néodyme présentent trois genres d'émission, représentés sur la figure 2, entre l'état excité $^4F_{3/2}$ présentant une énergie $E_1$ et l'état $^4I$ présentant quatre sous-niveaux d'énergie E croissante, $^4I_{9/2}$, $^4I_{11/2}$, $^4I_{13/2}$, $^4I_{15/2}$.

L'émission entre le niveau excité $E_1$ et le niveau $^4I_{9/2}$ présente une longueur d'onde $\lambda_1$ voisine de 0,89 µm l'émission entre le niveau excité $E_1$ et le niveau $^4I_{11/2}$ une longueur d'onde $\lambda_2$ voisine de 1,06 µm et l'émission entre le niveau excité $E_1$ et le niveau $^4I_{13/2}$ une longueur d'onde $\lambda_3$ voisine de 1,32 µm.

L'émission à la longueur d'onde 1,06 µm permet d'utiliser ces oxydes mixtes dans des lasers travaillant dans l'infrarouge.

Les émissions aux longueurs d'onde de 1,06 et 1,32 µm devraient permettre d'utiliser ces oxydes mixtes dans le domaine des télécommunications par fibres optiques. En effet, les fibres optiques par exemple en silice, qui sont plus ou moins absorbantes aux longueurs d'onde à transmettre, ont une faible atténuation à ces longueurs d'onde, ce qui permet la transmission d'un maximum d'informations.

Pour réaliser le peuplement de l'état excité $^4F_{3/2}$ d'énergie $E_1$, on excite les atomes jusqu'à un niveau d'énergie $E_2$ tel que $E_2$ soit supérieur à $E_1$. Le peuplement de l'état d'énergie $E_2$ est obtenu par absorption de lumière. Le niveau d'énergie $E_2$ étant très instable, les ions $Nd^{3+}$ se désexcitent spontanément jusqu'à l'état d'énergie $E_1$, état $^4F_{3/2}$. Cette méthode de peuplement de l'état excité $^4F_{3/2}$ est connue sous le nom de pompage optique. Du fait que les pics d'absorption du néodyme sont très étroits, on peut favoriser dans certains cas l'absorption de lumière de ces oxydes mixtes en substituant par exemple, 1% des ions aluminium par des ions de métaux de transition et de préférence par du chrome. En effet, ce dernier présente dans le visible deux bandes d'absorption beaucoup plus large (400 à 500 nanomètres et 600 à 700 nanomètres).

L'énergie due à l'absorption de lumière par le chrome peut être transmise aux ions $Nd^{3+}$, ce qui permet le peuplement du niveau d'énergie $E_1$.

Les propriétés physiques des oxydes mixtes selon l'invention, telles que les propriétes mécaniques et thermiques sont voisines des propriétés physiques de l'alumine.

Des études de propriétes magnétiques effectuées sur l'oxyde $NdMg\ Al_{11}O_{10}$ ont révélé que cet oxyde présente une importante anisotropie de sa susceptibilité magnétique principalement aux basses températures.

Les oxydes mixtes contenant du néodyme associé à du gadolinium ou du lanthane présentent des propriétés optiques permettant de les utiliser comme émetteur pour laser travaillant dans le domaine infrarouge et trouvant des applications par exemple dans le traitement des matériaux ou les télécommunications par fibre optique.

Tableau

| Oxydes mixtes | Nombre d'ions $Nd^{3+}$ par $cm^3$ ($x10^{21}$) | Temps de vie de l'état excité $^4F_{3/2}$ en micro-seconde |
|---|---|---|
| $NdMgAl_{11}O_{19}$ | 3,36 | 27 |
| $Nd_{0,33}La_{0,66}MgAl_{11}O_{19}$ | 1,12 | 52 |
| $Nd_{0,1}La_{0,9}MgAl_{11}O_{19}$ | 0,34 | 260 |
| $Nd_{0,05}La_{0,95}MgAl_{11}O_{19}$ | 0,17 | 360 |
| $Nd_{0,01}La_{0,99}MgAl_{11}O_{19}$ | 0,03 | 360 |
| $Y_3Al_5O_{12}$ avec 1% $Nd^{3+}$ | 0,14 | 200 à 240 |

**Revendications pour les États contractants: BE, CH, DE, FR, GB, IT, LI, LU, NL, SE**

1. Oxyde mixte d'aluminium caractérisé en ce qu'il présente la formule suivante:

$$X^1_{(x_1-x_2)}X^2_{(x_2)}M^1_{(y_1-y_2)}M^2_{(y_2)}Al_{(z_1-z_2)}M^3_{(z_2)}O_{19}$$

dans laquelle, $X^1$ représente le lanthane ou le gadolinium; $X^2$ représente le néodyme; $M^1$ et $M^2$ qui peuvent être identiques ou différents représentent un métal choisi parmi le magnésium et les métaux de transition bivalents; $M^3$ représente un métal de transition trivalent; $x_1$ représente un nombre allant de 0,8 à 1; $y_1$ représente un nombre allant de 0,7 à 1; $z_1$ représente un nombre allant de 10 à 12; $x_2$ représente un nombre tel que $0<x_2\leq x_1$; $y_2$ représente un nombre allant de 0 à $y_1$; et $z_2$ représente un nombre allant de 0 à 1, et en ce qu'il présente une structure cristalline du type magnétoplombite.

2. Oxyde mixte selon la revendication 1, caractérisé en ce que $x_1$ est égal à 1, $y_1$ à 1 et $z_1$ à 11.

3. Oxyde mixte selon la revendication 1, caractérisé en ce que $x_1$ est égal à 0,95, $y_1$ à 1 et $z_1$ à 11.

4. Oxyde mixte selon la revendication 1, caractérisé en ce que $x_1$ est égal à 1, $y_1$ à 0,9 et $z_1$ à 11.

5. Oxyde mixte selon l'une quelconque des revendications 1 à 4, caractérisé en ce que les métaux de transition $M^1$ et $M^2$ sont choisis parmi le manganèse, le fer, le nickel et le cobalt.

6. Oxyde mixte selon l'une quelconque des revendications 1 à 5, caractérisé en ce que $M^3$ est le chrome.

7. Oxyde mixte selon l'une quelconque des revendications 1 à 6, caractérisé en ce que $M^1$ est le magnésium.

8. Oxyde mixte selon la revendication 7, caractérisé en ce que $x_2$ est égal à 0,1.

9. Oxyde mixte selon la revendication 7, caractérisé en ce qu'il présente la formule:

$$La_{0,9}Nd_{0,1}MgAl_{11}O_{19}.$$

10. Procédé de fabrication d'un oxyde mixte selon l'une quelconque des revendications 1 à 9, caractérisé en ce que l'on mélange intimement dans des proportions convenables les poudres des oxydes de $X^1$, $X^2$, $M^1$, $M^2$, $M^3$ et d'aluminium et en ce que l'on fond le mélange obtenu.

11. Procédé selon la revendication 10, caractérisé en ce que l'on traite le mélange fondu de façon à obtenir par solidification dudit mélange un monocristal.

12. Procédé selon l'une quelconque des revendications 10 et 11, caractérisé en ce que l'on mélange les oxydes avant la fusion, dans un solvant organique que l'on élimine ensuite par évaporation.

13. Procédé selon la revendication 12, caractérisé en ce que le solvant organique est choisi parmi l'éther et l'acétone.

14. Procédé de fabrication d'un oxyde mixte selon l'une quelconque des revendications 1 à 9, caractérisé en ce que l'on coprécipite les hydroxydes de sels de $X^1$, $X^2$, $M^1$, $M^2$, $M^3$ et d'aluminium dissous dans un solvant non aqueux dans des proportions convenables et en ce que l'on calcine le coprécipité obtenu.

15. Procédé selon la revendication 14, caractérisé en ce que l'on fond le coprécipité après broyage de celui-ci et en ce que l'on traite le coprécipité fondu de façon à obtenir par solidification dudit coprécipité un monocristal.

16. Procédé selon l'une quelconque des revendications 15 et 15, caractérisé en ce que l'on coprécipité les hydroxydes par de l'ammoniaque.

17. Procédé selon l'une quelconque des revendications 14 à 16, caractérisé en ce que le solvant non aqueux est de l'alcool absolu.

18. Application aux lasers de puissance émettant dans l'infrarouge d'un monocristal d'un oxyde mixte selon l'une quelconque des revendications 1 à 9.

19. Application aux télécommunications par fibres optiques d'un monocristal d'un oxyde mixte selon l'une quelconque des revendications 1 à 9.

**Revendications pour l'État contractant: AT**

1. Procédé de fabrication d'un oxyde mixte d'aluminium présentant la formule suivante:

$$X^1_{(x_1-x_2)}X^2_{(x_2)}M^1_{(y_1-y_2)}M^2_{(y_2)}Al_{(z_1-z_2)}M^3_{(z_2)}O_{19}$$

dans laquelle, $X^1$ représente le lanthane ou le gadolinium; $X^2$ représente le néodyme; $M^1$ et $M^2$ qui peuvent être identiques ou différents représentent un métal choisi parmi le magnésium et les métaux de transition bivalents; $M^3$ représente un métal de transition trivalent; $x_1$ représente un nombre allant de 0,8 à 1; $y_1$ représente un nombre allant de 0,7 à 1; $z_1$ représente un nombre allant de 10 à 12; $x_2$ représente un nombre tel que $0 < x_2 \leq x_1$; $y_2$ représente un nombre allant de 0 à $y_1$; et $z_2$ représente un nombre allant de 0 à 1, et présentant une structure cristalline du type magnétoplombite, caractérisé en ce que l'on mélange intimement dans des proportions convenables les poudres des oxydes de $X^1$, $X^2$, $M^1$, $M^2$, $M^3$ et d'aluminium et en ce que l'on fond le mélange obtenu.

2. Procédé selon la revendication 1, caractérisé en ce que l'on traite le mélange fondu de façon à obtenir par solidification dudit mélange un monocristal.

3. Procédé selon l'une quelconque des revendications 1 et 2, caractérisé en ce que l'on mélange les oxydes avant la fusion, dans un solvant organique que l'on élimine ensuite par évaporation.

4. Procédé selon la revendication 3, caractérisé en ce que le solvant organique est choisi parmi l'éther et l'acétone.

5. Procédé de fabrication d'un oxyde mixte d'aluminium présentant la formule suivante:

$$X^1_{(x_1-x_2)}X^2_{(x_2)}M^1_{(y_1-y_2)}M^2_{(y_2)}Al_{(z_1-z_2)}M^3_{(z_2)}O_{19}$$

dans laquelle, $X^1$ représente le lanthane ou le gadolinium; $X^2$ représente le néodyme; $M^1$ et $M^2$ qui peuvent être identiques ou différents représentent un métal choisi parmi le magnésium et les métaux de transition bivalents; $M^3$ représente un métal de transition trivalent; $x_1$ représente un nombre allant de 0,8 à 1; $y_1$ représente un nombre allant de 0,7 à 1; $z_1$ représente un nombre allant de 10 à 12; $x_2$ représente un nombre tel que $0 < x_2 \leq x_1$; $y_2$ représente un nombre allant de 0 à $y_1$; et $z_2$ représente un nombre allant de 0 à 1, et présentant une structure cristalline du type magnétoplombite, caractérisé en ce que l'on coprécipite les hydroxydes de sels de $X^1$, $X^2$, $M^1$, $M^2$, $M^3$ et d'aluminium dissous dans un solvant non aqueux dans des proportions convenables et en ce que l'on calcine le coprécipité obtenu.

6. Procédé selon la revendication 5, caractérisé en ce que l'on fond le coprécipité après broyage de celui-ci et en ce que l'on traite le coprécipité fondu de façon à obtenir par solidification dudit coprécipité un monocristal.

7. Procédé selon l'une quelconque des revendications 5 et 6, caractérisé en ce que l'on coprécipite les hydroxydes par de l'ammoniaque.

8. Procédé selon l'une quelconque des revendications 5 à 7, caractérisé en ce que le solvant non aqueux est de l'alcool absolu.

9. Procédé selon l'une quelconque des revendications 1 à 8, caractérisé en ce que $x_1$ est égal à 1, $y_1$ à 1 et $z_1$ à 11.

10. Procédé selon l'une quelconque des revendications 1 à 8, caractérisé en ce que $x_1$ est égal à 0,95, $y_1$ à 1 et $z_1$ à 11.

11. Procédé selon l'une quelconque des revendications 1 à 8, caractérisé en ce que $x_1$ est égal à 0,95, $y_1$ à 0,9 et $z_1$ à 11.

12. Procédé selon l'une quelconque des revendications 1 à 11, caractérisé en ce que les métaux de transition $M^1$ et $M^2$ sont choisis parmi le manganèse, le fer, le nickel et le cobalt.

13. Procédé selon l'une quelconque des revendications 1 à 12, caractérisé en ce que $M^3$ est le chrome.

14. Procédé selon l'une quelconque des revendications 1 à 13, caractérisé en ce que $M^1$ est le magnésium.

15. Procédé selon la revendication 14, caractérisé en ce que $x_2$ est égal à 0,1.

16. Procédé selon la revendication 1 ou 5, caractérisé en ce que l'oxyde mixte présente la formule:

$$La_{0,9}Nd_{0,1}MgAl_{11}O_{19}.$$

17. Application aux lasers de puissance émettant dans l'infrarouge d'un monocristal d'un oxcyde

mixte d'aluminium fabriqué selon l'une quelconque des revendications 1 à 16.

18. Application aux télécommunications par fibres optiques d'un monocristal d'un oxyde mixte d'aluminium fabriqué selon l'une quelconque des revendications 1 à 16.

**Patentansprüche für die Vertragsstaaten: BE, CH, DE, FR, GB, IT, LI, LU, NL, SE**

1. Aluminium-Mischoxid, dadurch gekennzeichnet, daß es gemäß der folgenden Formel vorliegt:

$$X^1_{(x_1-x_2)}X^2_{(x_2)}M^1_{(y_1-y_2)}M^2_{(y_2)}Al_{(z_1-z_2)}M^3_{(z_2)}O_{19}$$

worin $X^1$ Lanthan oder Gadolin bezeichnet; $X^2$ das Neodym bezeichnet; $M^1$ und $M^2$, welche identisch oder voneinander verschieden sein können, eines der Metalle Magnesium unter der zweiwertigen Übergangsmetalle bezeichnen; $M^3$ ein dreiwertiges Übergangsmetall bezeichnet; $x_1$ eine Zahl von 0,8 bis 1 bezeichnet; $y_1$ eine Zahl von 0,7 bis 1 bezeichnet; $z_1$ eine Zahl von 10 bis 12 bezeichnet; $x_2$ eine Zahl bezeichnet, für welche gilt $0 < x_2 \leq x_1$; $y_2$ eine Zahl von 0 bis $y_1$ bezeichnet und $z_2$ eine Zahl von 0 bis 1 bezeichnet, und daß das Mischoxid ein kristallines Gefüge vom Magnetoplombid-Typ aufweist.

2. Mischoxid nach Anspruch 1, dadurch gekennzeichnet, daß $x_1$ gleich 1 ist, daß $y_1$ gleich 1 ist und daß $z_1$ gleich 11 ist.

3. Mischoxid nach Anspruch 1, dadurch gekennzeichnet, daß $x_1$ gleich 0,95 ist, daß $y_1$ gleich 1 ist und daß $z_1$ gleich 11 ist.

4. Mischoxid nach Anspruch 1, dadurch gekennzeichnet, daß $x_1$ gleich 1 ist, daß $y_1$ gleich 0,9 ist und daß $z_1$ gleich 11 ist.

5. Mischoxid nach einem der Ansprüche 1 bis 4, dadurch gekennzeichnet, daß die Übergangsmetalle $M^1$ und $M^2$ ausgewählt sind aus einer Mangan, Eisen, Nickel und Koblat umfassenden Gruppe.

6. Mischoxid nach einem der Ansprüche 1 bis 5, dadurch gekennzeichnet, daß $M^3$ Chrom bezeichnet.

7. Mischoxid nach einem der Ansprüche 1 bis 6, dadurch gekennzeichnet, daß $M^1$ Magnesium bezeichnet.

8. Mischoxid nach Anspruch 7, dadurch gekennzeichnet, daß $x_2$ gleich 0,1 ist.

9. Mischoxid nach Anspruch 1, dadurch gekennzeichnet, daß es die folgende Formel aufweist:

$$La_{0,9}Nd_{0,1}MgAl_{11}O_{19}.$$

10. Verfahren zum Herstellen eines Mischoxides nach einem der Ansprüche 1 bis 9, dadurch gekennzeichnet, daß man in den geeigneten Anteilen Pulver der Oxide von $X^1$, $X^2$, $M^1$, $M^2$, $M^3$ sowie von Aluminium innig mischt und daß man die erhaltene Mischung schmilzt.

11. Verfahren nach Anspruch 10, dadurch gekennzeichnet, daß die geschmolzene Mischung so behandelt wird, daß durch Erstarren dieser Mischung ein Einkristall entsteht.

12. Verfahren nach einem der Ansprüche 10 und 11, dadurch gekennzeichnet, daß man die Oxide vor dem Schmelzen in einem organischen Lösungsmittel vermischt, welches anschließend durch Verdampfen entfernt wird.

13. Verfahren nach Anspruch 12, dadurch gekennzeichnet, daß als organisches Lösungsmittel entweder Ether oder Aceton verwendet wird.

14. Verfahren zum Herstellen eines Mischoxides nach einem der Ansprüche 1 bis 9, dadurch gekennzeichnet, daß man nebeneinander die Hydroxide der Salze von $X^1$, $X^2$, $M^1$, $M^2$, $M^3$ sowie von Aluminium gelöst in einem nicht wäßrigen Lösungsmittel in den entsprechenden Anteilen ausfällt und daß man das erhaltene Ausgefällte kalziniert.

15. Verfahren nach Anspruch 14, dadurch gekennzeichnet, daß man das Ausgefällte nach dem Zerkleinern desselben schmilzt und daß man das geschmolzene Ausgefällte so behandelt, daß nach dem Erstarren des Ausgefällten ein Einkristall vorliegt.

16. Verfahren nach einem der Ansprüche 14 und 15, dadurch gekennzeichnet, daß man die Hydroxide mit Hilfe von Ammoniak ausfällt.

17. Verfahren nach einem der Ansprüche 14 bis 16, dadurch gekennzeichnet, daß als nicht wäßriges Lösungsmittel reiner Alkohol benutzt wird.

18. Verwendung eines Mischoxid-Einkristalls nach einem der Ansprüche 1 bis 9 für Infrarot-Leistungslaser.

19. Verwendung eines Mischoxid-Einkristalls nach einem der Ansprüche 1 bis 9 für optische Fernmeldefasern.

**Patentansprüche für den Vertragsstaat: AT**

1. Verfahren zum Herstellen eines Aluminium-Mischoxides der folgenden Formel:

$$X^1_{(x_1-x_2)}X^2_{(x_2)}M^1_{(y_1-y_2)}M^2_{(y_2)}Al_{(z_1-z_2)}M^3_{(z_2)}O_{19}$$

in welcher $X^1$ Lanthan oder Gadolinium bezeichnet; $X^2$ Neodym bezeichnet; $M^1$ und $M^2$, welche identisch oder unterschiedlich sein können, Magnesium oder die zweiwertigen Übergangsmetalle bezeichnen; $M^3$ ein dreiwertiges Übergangsmetall bezeichnet; $x_1$ eine Zahl von 0,8 bis 1 bezeichnet; $y_1$ eine Zahl von 0,7 bis 1 bezeichnet; $z_1$ eine Zahl von 10 bis 12 bezeichnet; $x_2$ eine Zahl bezeichnet, für welche gilt $0 < x_2 \leq x_1$; $y_2$ eine Zahl von 0 bis $y_1$ bezeichnet; und $z_2$ eine Zahl von 0 bis 1 bezeichnet, wobei das Mischoxid ein kristallines Gefüge vom Magnetoplombid-Typ aufweist, dadurch gekennzeichnet, daß man innig in den geeigneten Anteilen die Puder der Oxide von $X^1$, $X^2$, $M^1$, $M^2$, $M^3$ und von Aluminium mischt und daß man die erhaltene Mischung schmilzt.

2. Verfahren nach Anspruch 1, dadurch gekennzeichnet, daß man die geschmolzene Mischung derart behandelt, daß nach dem Erstarren derselben ein Einkristall erhalten wird.

3. Verfahren nach einem der Ansprüche 1 oder 2, dadurch gekennzeichnet, daß man die Oxide vor dem Schmelzen in einem organischen Lösungsmittel mischt, welches man anschließend durch Verdampfen entfernt.

4. Verfahren nach Anspruch 3, dadurch gekennzeichnet, daß als organisches Lösungsmittel Ether oder Aceton verwendet wird.

5. Verfahren zum Herstellen eines Aluminium-Mischoxides der folgenden Formel:

$$X^1_{(x_1-x_2)}X^2_{(x_2)}M^1_{(y_1-y_2)}M^2_{(y_2)}Al_{(z_1-z_2)}M^3_{(z_2)}O_{19}$$

in welcher $X^1$ Lanthan oder Gadolinium bezeichnet; $X^2$ Neodym bezeichnet; $M^1$ und $M^2$, welche identisch oder voneinander verschieden sein können, ein aus Magnesium und den zweiwertigen Übergangsmetallen ausgewähltes Metall bezeichnen; $M^3$ ein dreiwertiges Übergangsmetall bezeichnet; $x_1$ eine Zahl von 0,8 bis 1 bezeichnet; $y_1$ eine Zahl von 0,7 bis 1 bezeichnet; $z_1$ eine Zahl von 10 bis 12 bezeichnet; $x_2$ eine Zahl bezeichnet, für welche gilt $0 < x_2 \leq x_1$; $y_2$ eine Zahl von 0 bis $y_1$ bezeichnet; und $z_2$ eine Zahl von 0 bis 1 bezeichnet, wobei das Mischoxid ein Kristallgefüge des Magnetoplombid-Typs aufweist, dadurch gekennzeichnet, daß man die Hydroxide von Salzen des $X^1$, $X^2$, $M^1$, $M^2$, $M^3$ und von Aluminium in einem nicht wäßrigen Lösungsmittel in den entsprechenden Anteilen gelöst nebeneinander ausfällt und daß man das derart Ausgefällte kalziniert.

6. Verfahren nach Anspruch 5, dadurch gekennzeichnet, daß man das Ausgefällte nach dem Zerkleinern desselben schmilzt und daß man das geschmolzene Ausgefällte derart behandelt, daß nach dem Erstarren desselben ein Einkristall erhalten wird.

7. Verfahren nach einem der Ansprüche 5 und 6, dadurch gekennzeichnet, daß man die Hydroxide mit Hilfe von Ammoniak ausfällt.

8. Verfahren nach einem der Ansprüche 5 bis 7, dadurch gekennzeichnet, daß als nicht wäßriges Lösungsmittel reiner Alkohol verwendet wird.

9. Verfahren nach einem der Ansprüche 1 bis 8, dadurch gekennzeichnet, daß $x_1$ gleich 1 ist, daß $y_1$ gleich 1 ist und daß $z_1$ gleich 11 ist.

10. Verfahren nach einem der Ansprüche 1 bis 8, dadurch gekennzeichnet, daß $x_1$ gleich 0,95 ist, daß $y_1$ gleich 1 ist und daß $z_1$ gleich 11 ist.

11. Verfahren nach einem der Ansprüche 1 bis 8, dadurch gekennzeichnet, daß $x_1$ gleich 1 ist, daß $y_1$ gleich 0,9 ist und daß $z_1$ gleich 11 ist.

12. Verfahren nach einem der Ansprüche 1 bis 11, dadurch gekennzeichnet, daß die Übergangsmetalle $M^1$ und $M^2$ ausgewählt werden aus einer Mangan, Eisen, Nickel und Kobalt enthaltenden Gruppe.

13. Verfahren nach einem der Ansprüche 1 bis 12, dadurch gekennzeichnet, daß $M^3$ Chrom ist.

14. Verfahren nach einem der Ansprüche 1 bis 13, dadurch gekennzeichnet, daß $M^1$ Magnesium ist.

15. Verfahren nach Anspruch 14, dadurch gekennzeichnet, daß $x_2$ gleich 0,1 ist.

16. Verfahren nach Anspruch 1 oder 5, dadurch gekennzeichnet, daß das Mischoxid die Formel

$$La_{0,9}Nd_{0,1}MgAl_{11}O_{19}$$

aufweist.

17. Verwendung eines Aluminium-Mischoxids-Einkristalls, hergestellt nach einem der Ansprüche 1 bis 16 für Infrarot-Leistungslaser.

18. Verwendung eines Aluminium-Mischoxid-Einkristalls, hergestellt nach einem der Ansprüche 1 bis 16, für optische Fernmeldefasern.

**Claims for the contracting states: BE, CH, DE, FR, GB, IT, LI, LU, NL, SE**

1. A mixed aluminium oxide, characterized in that it has the following formula:

$$X^1_{(x_1-x_2)}X^2_{(x_2)}M^1_{(y_1-y_2)}M^2_{(y_2)}Al_{(z_1-z_2)}M^3_{(z_2)}O_{19}$$

wherein $X^1$ represents lanthanum or gadolinium; $X^2$ represents neodymium; $M^1$ and $M^2$, which may be the same or different, each represents a metal selected from magnesium and bivalent transition metals; $M^3$ represents a trivalent transition metal; $x_1$ represents a numer from 0.8 to 1; $y_1$ represents a number from 0.7 to 1; $z_1$ represents a number from 10 to 12; $x_2$ represents a number such that $0<x_2\leq x_1$; $y_2$ represents a number from 0 to $y_1$; and $z_2$ represents a number from 0 to 1; and in that it has a crystal structure of the magnetoplumbite type.

2. A mixed oxide according to Claim 1, characterized in that $x_1$ is 1, $y_1$ is 1, and $z_1$ is 11.

3. A mixed oxide according to Claim 1, characterized in that $x_1$ is 0.95, $y_1$ is 1, and $z_1$ is 11.

4. A mixed according to Claim 1, characterized in that $x_1$ is 1, $y_1$ is 0.9 and $z_1$ is 11.

5. A mixed oxide according to any one of Claims 1 to 4, characterized in that the transition metals $M^1$ and $M^2$ are selected from manganese, iron, nickel and cobalt.

6. A mixed oxide according to any one of Claims 1 to 5, characterized in that $M^3$ is chromium.

7. A mixed oxide according to any one of Claims 1 to 6, characterized in that $M^1$ is magnesium.

8. A mixed oxide according to Claim 7, characterized in that $x_2$ is 0.1.

9. A mixed oxide according to Claim 1, characterized in that it has the formula:

$$La_{0.9}Nd_{0.1}MgAl_{11}O_{19}$$

10. A process for the production of a mixed oxide according to any one of Claims 1 to 9, characterized in that powdered oxides of $X^1$, $X^2$, $M^1$, $M^2$, $M^3$ and aluminium are mixed in suitable proportions, and in that the resulting mixture is fused.

11. A process according to Claim 10, characterized in that the fused mixture is treated whereby to form a monocrystal by solidification of the mixture.

12. A process according to either of Claims 10 and 11, characterized in that the oxides ares mixed, before fusion, in an organic solvent which is subsequently removed by evaporation.

13. A process according to Claim 12, characterized in that the organic solvent is selected from ether and acetone.

14. A process for the production of a mixed oxide according to any of Claims 1 to 9, characterized in that hydroxides are coprecipitated from salts of $X^1$, $X^2$, $M^1$, $M^2$, $M^3$ and aluminium dissolved in suitable proportions in a non-aqueous solvent, and in that the resulting coprecipitate is calcined.

15. A process according to Claim 14, characterized in that the coprecipitate is fused after grinding thereof, and in that the fused coprecipitate is treated whereby to form a monocrystal by solidification of said coprecipitate.

16. A process according to either of Claims 14 and 15, characterized in that the hydroxides are coprecipitated by ammonia.

17. A process according to any one of Claims 14 to 16, characterized in that the non-aqueous solvent is absolute alcohol.

18. The application of a monocrystal of a mixed oxide according to any one of Claims 1 to 9 to power lasers emitting in the infra-red.

19. The application of a monocrystal of a mixed oxide according to any one of Claims 1 to 9, to telecommunications by means of fibre optics.

**Claims for the contracting state: AT**

1. A process for the production of a mixed aluminium oxide, having the following formula:

$$X^1_{(x_1-x_2)}X^2_{(x_2)}M^1_{(y_1-y_2)}M^2_{(y_2)}Al_{(z_1-z_2)}M^3_{(z_2)}O_{19}$$

wherein $X^1$ represents lanthanum or gadolinium; $X^2$ represents neodymium; $M^1$ and $M^2$, which may be the same or different, each represents a metal selected from magnesium and bivalent transition metals; $M^3$ represents a trivalent transition metal; $x_1$ represents a numer from 0.8 to 1; $y_1$ represents a number from 0.7 to 1; $z_1$ represents a numer from 10 to 12; $x_2$ represents a number such that $0<x_2\leq x_1$; $y_2$ represents a number from 0 to $y_1$; and $z_2$ represents a number from 0 to 1; and having a crystal structure of the magnetoplumbite type, characterized in that powdered oxides of $X^1$, $X^2$, $M^1$, $M^2$, $M^3$ and aluminium are mixed in suitable proportions, and in that the resulting mixture is fused.

2. A process according to Claim 1, characterized in that the fused mixture is treated whereby to form a monocrystal by solidification of the mixture.

3. A process according to either of Claims 1 and 2, characterized in that the oxides are mixed, before

fusion, in an organic solvent which is subsequently removed by evaporation.

4. A process according to Claim 3, characterized in that the organic solvent is selected from ether and acetone.

5. A process for the production of a mixed aluminium oxide, characterized in that hydroxides are coprecipitated from salts of $X^1$, $X^2$, $M^1$, $M^2$, $M^3$ and aluminium dissolved in suitable proportions in a non-aqueous solvent, and in that the resulting coprecipitate is calcined.

6. A process according to Claim 5, characterized in that the coprecipitate is fused after grinding thereof, and in that the fused coprecipitate is treated whereby to form a monocrystal by solidification of said coprecipitate.

7. A process according to either of Claims 5 and 6, characterized in that the hydroxides are coprecipitated by ammonia.

8. A process according to any one of Claims 5 to 7, characterized in that the non-aqueous solvent is absolute alcohol.

9. A process according to any one of Claims 1 to 8, characterized in that $x_1$ is 1, $y_1$ is 1, and $z_1$ is 11.

10. A process according to any one of Claims 1 to 8, characterized in that $x_1$ is 0.95, $y_1$ is 1 and $z_1$ is 11.

11. A process according to any one of Claims 1 to 8, characterized in that $x_1$ is 1, $y_1$ is 0.9, and $z_1$ is 11.

12. A process according to any one of Claims 1 to 11, characterized in that the transition metals $M^1$ and $M^2$ are selected from manganese, iron, nickel and cobalt.

13. A process according to any one of Claims 1 to 12, characterized in that $M^3$ is chromium.

14. A process according to any one of Claims 1 to 13, characterized in that $M^1$ is magnesium.

15. A process according to Claim 14, characterized in that $x_2$ is 0.1.

16. A process according to Claim 1 or 5, characterized in that the mixed oxide has the formula:

$$La_{0.9}Nd_{0.1}MgAl_{11}O_{19}$$

17. The application of a monocrystal of a mixed oxide produced according to any one of Claims 1 to 16 to power lasers emitting in the infra-red.

18. The application of a monocrystal of a mixed oxide produced according to any one of Claims 1 to 16, to telecommunications by means of fibre optics.

FIG.1

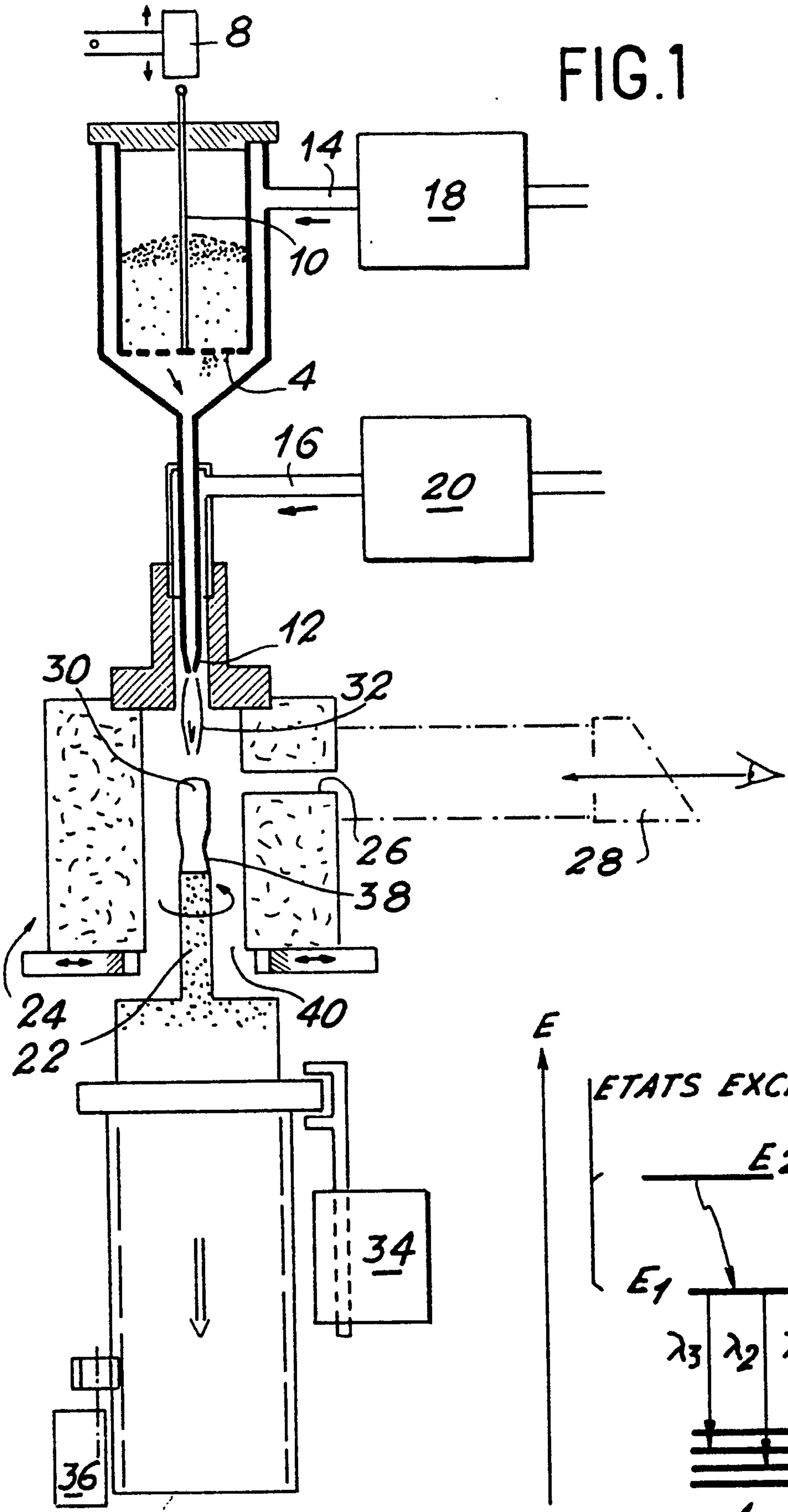
8
14
18
10
4
16
20
12
30
32
26
28
38
24
40
22
34
36

FIG.2

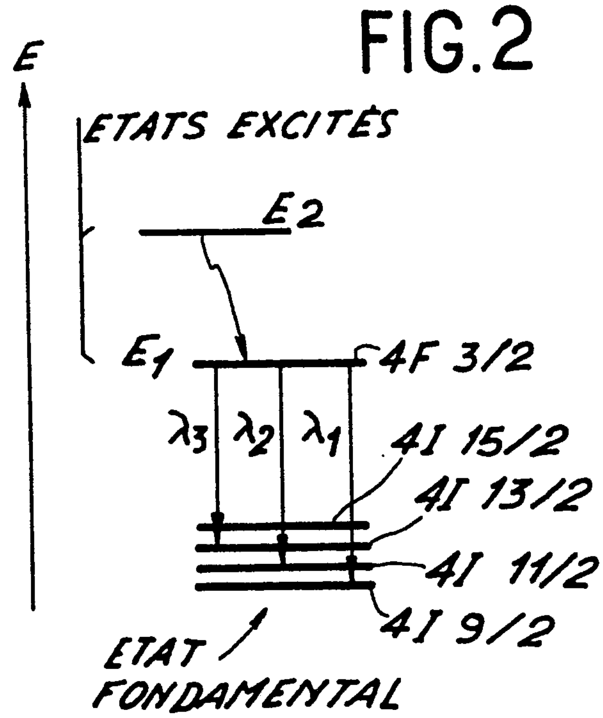
E
ETATS EXCITÉS
E2
E1
4F 3/2
λ3
λ2
λ1
4I 15/2
4I 13/2
4I 11/2
4I 9/2
ETAT
FONDAMENTAL